# EUROPEAN PATENT APPLICATION

(11) **EP 4 776 829 A1**
(43) Date of publication of application: **15.07.2026**
(21) Application number: 25217828.0
(22) Date of filing: 21.11.2025
(51) Int. Cl.: H10P 72/70

(54) **METHOD OF PLASMA PROCESSING A WORKPIECE**

(30) Priority: 14.01.2025 GB 202500461
(71) Applicant: SPTS Technologies Limited, Newport Gwent NP18 2TA (GB)
(72) Inventor: FAN, Weikang, Newport, NP18 2TA (GB)
(74) Representative: Wynne-Jones IP Limited

(57) **Abstract**

According to the invention there is provided a method of plasma processing a workpiece that is susceptible to arcing comprising the steps of:
providing a workpiece having an upper portion comprising at least one insulating layer and a lower surface opposite the upper portion;
applying a conductive layer to the lower surface;
positioning the workpiece on a workpiece support of a plasma processing apparatus with the lower surface of the workpiece closest to the workpiece support;
plasma processing the workpiece in the plasma processing apparatus, wherein the plasma processing comprises applying a **RF** electrical signal with an associated **RF** power to the workpiece support; and
removing the conductive layer from the plasma processed workpiece.

## Description

### Field of the Disclosure

This invention relates to a method of plasma processing a workpiece. The invention relates also to an associated system for plasma processing and a workpiece.

### Background of the Disclosure

It is known in plasma processing to drive a substrate support having a wafer positioned thereon with a radio frequency (RF) electrical supply at reduced pressure. The chamber of the system is grounded and a capacitively coupled plasma is generated above the substrate support. Such a configuration is well known in dry etch tools and PECVD (plasma enhanced chemical vapour deposition) systems. As the RF power is increased a negative DC bias on the wafer support increases. This in turn, in certain circumstances, can result in arcing in the chamber. Arcing is defined by a sudden large current across the plasma sheath from the bulk plasma to the substrate surface where normally there should be only a small current from motion of the ions. Arcing can result in damage to the chamber, the wafer support and the wafer itself as a high current passes from the wafer support though the arc to ground. This can result in excessive heating or melting of components. This is undesirable as it may result in chamber intervention to replace the damaged parts and wafer yield loss.

To plasma etch dielectric films such as SiO₂,where there is strong Si-O bonding, a high bias process is frequently used to support high etch rates. An etchant gas mixture comprising CₓF_{y} and/or CₓH_{y}F_{z} with O₂ or CO and Ar gases can be used to produce high ion energies delivered through sheath acceleration. Similar issues can occur with other dielectric or resistive semiconductor films such as SiC where strong Si-C bonds also require a strong physical etch component which also requires high substrate bias voltages.

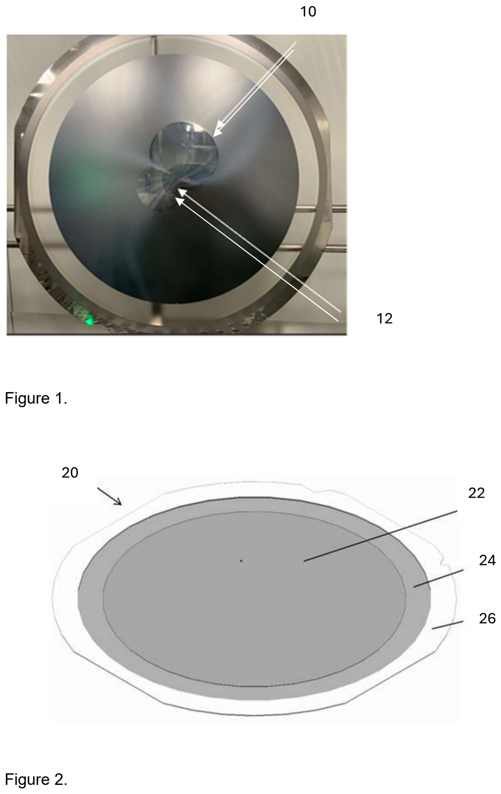

A particular case where great care must be taken to avoid arcing while etching SiO₂ is during a plasma dicing process where relatively thick dielectric layers (3-10 microns), potentially including TEG (Test Element Group) or metal layers within the dielectric layer, reside in the street regions above the surface of a silicon substrate. In this case, the wafer being diced is supported on a tape and frame carrier arrangement or a support wafer as is well known in the art. The carrier tape is at particular risk of overheating due to the process conditions. Typically, the carrier tape is formed from a polymeric material such as a polyolefin (PO) polyvinyl chloride (PVC) or polyethylene terephthalate (PET) with a softening point of around 90° C. In practice, it is considered necessary to maintain the temperature of the carrier tape at 80° C or less during processing to avoid damage to the tape or to the acrylic adhesive used on the tape. Thermal runaway is a constant risk as the thickness of the tape is typically less than 200 microns and therefore the tape has a low thermal capacity. Arcing events in the vicinity of the wafer can not only result in yield loss but can also damage the tape as it is heated above the glass transition temperature T_{g}. This in turn can adversely affect other dies on the tape and result in contamination of the wafer support. As an example, Figure 1 is a photograph of a wafer on a tape and frame carrier showing two regions of arcing 10, 12 which occurred when operating at high RF bias powers of about 3kW while etching SiO₂. The localized heating resulted in burning of the sample surface.

In general, plasma dicing is performed in one of two ways. In the first approach, plasma dicing is carried out after the wafer has been thinned or ground to the required thickness. This is commonly described as Dicing After Grid (DAG). In the second approach, plasma dicing is carried out before wafer thinning wherein the plasma dicing step is stopped prior to singulation. This is known as Dicing Before Grid (DBG). Following a DBG process the wafer is inverted and is ground or otherwise thinned to singulate the die.

Some previous methods for addressing these problems have used lower RF power or a less dense plasma in order to lower the voltage delivered. This results in a lower etch rate, which is undesirable. Other previous methods for addressing these problems have involved modifying the cathode electrode (the wafer structure and/or the platen chuck) to reduce arcing by improving electrical uniformity. It is undesirable to change the design of the apparatus in this way.

### Statement of Invention

The present invention, in at least some of its embodiments, addresses the above-described problems. In particular, the present invention, in at least some of its embodiments, provides a practical, low cost solution to the problem of arcing in the plasma processing of SiO₂, SiC and other insulating materials.

According to a first aspect of the invention there is provided a method of plasma processing a workpiece that is susceptible to arcing comprising the steps of:
providing a workpiece having an upper portion comprising at least one insulating layer and a lower surface opposite the upper portion;
applying a conductive layer to the lower surface;
positioning the workpiece on a workpiece support of a plasma processing apparatus with the lower surface of the workpiece closest to the workpiece support;
plasma processing the workpiece in the plasma processing apparatus, wherein the plasma processing comprises applying a RF electrical signal with an associated RF power to the workpiece support; and
removing the conductive layer from the plasma processed workpiece.

The insulating layer can be a dielectric layer or a resistive semiconductor layer.

The insulating layer can be a SiO₂, SiN or SiCO layer.

The insulating layer can be a SiC or SiC:H layer.

The workpiece can comprise more than one insulating layer. For example, the workpiece can comprise a laminate comprising a plurality of insulating layers, such as a SiO₂, SiN, SiO₂ tri-layer.

The insulating layer can be formed on a semiconductor substrate. The semiconductor substrate can be a silicon substrate. The semiconductor substrate can be a semiconductor wafer.

The plasma processing can be plasma etching of the insulating layer. The plasma etching can be performed using at least one fluorocarbon and/or SF₆ as etch gases, optionally with at least one of oxygen, CO and an inert gas such as argon present. The fluorocarbon can be a per-fluorocarbon or a hydrofluorocarbon. The fluorocarbon can be CₓF_{y} and/or CₓH_{y}F_{z}, where x can be 1 to 4, the fluorocarbon can be an alkane, an alkene or cyclic, and y and z are stoichiometrically appropriate integers.

The workpiece can be positioned on a tape and frame carrier arrangement, wherein: the plasma processing of the workpiece is a plasma dicing process; and the step of positioning the workpiece on the workpiece support is performed by positioning the tape and frame carrier arrangement carrying the workpiece on the workpiece support. Alternatively, the workpiece can be positioned directly onto the workpiece support. The plasma dicing process can be a DAG or a DBG process.

The plasma processing can be plasma enhanced chemical vapour deposition (PECVD).

The step of applying a conductive layer to the lower surface can comprise coating the lower surface with a conductive layer. The conductive layer can be a metal. The conductive layer can be copper, aluminium, nickel, tin or any other convenient metal or metal alloy.

The lower surface can be coated in a physical vapour deposition (PVD) or thermal sputtering process. Alternatively, the lower surface can be coated by applying a coating composition thereto. The lower surface can be coated with conductive silver, carbon ink or soldering glue.

The step of applying a conductive layer to the lower surface can comprise laminating the lower surface with a conductive layer. The lower surface can be laminated with a conductive tape. This provides a convenient and cost effective solution. The conductive tape can be an anti-ESD (electrostatic discharge) tape.

Where the workpiece is positioned on a tape and frame carrier arrangement, it is convenient to laminate the lower surface with a conductive layer. In one alternative, the conductive tape is the tape of the tape and frame carrier arrangement, and the lower surface is laminated by positioning the workpiece on the tape and frame carrier arrangement. In another alternative, the lower surface is laminated with the conductive tape and subsequently the workpiece is positioned on the tape and frame carrier arrangement. In this alternative, the tape of the tape and frame carrier arrangement might or might not be a conductive tape.

If desired, the conductive layer can relatively thin, i.e. less than 1 micron, although the invention is not limited in this respect.

A RF power of 1.5 kW or greater can be supplied to the workpiece support. A RF power of 2.0 kW or greater, optionally 2.5 kW or greater, can be supplied to the workpiece support.

In practice, the conductive layer can cover the entire lower surface of the workpiece. It might be possible to only cover a portion of lower surface with one or more conductive layers, although the portion of the lower surface covered should be sufficiently large that the effectiveness of the conductive layer to prevent or reduce arcing is not materially affected.

The workpiece can comprise a plurality of CMOS (complementary metal oxide semiconductor) devices. The invention is well suited to the manufacture of CMOS devices, although the invention is not limited in this regard. The plasma processing can comprise plasma dicing of the workpiece to singulate the plurality of CMOS devices.

The step of removing the conductive layer from the plasma processed workpiece can comprise any suitable method. Where a conductive layer such as a conductive tape is laminated to the lower surface, the step of removing the conductive layer can comprise peeling the conductive layer from the lower surface or removing the plasma processed workpiece from the conductive layer. Alternatively, the step of removing the conductive layer from the plasma processed workpiece can comprise a wet chemical etch and/or grinding.

According to a second aspect of the invention there is provided a system for plasma processing a workpiece that is susceptible to arcing in a method according to the first aspect of the invention, the system comprising:
a module for applying a conductive layer to the lower surface of the workpiece;
a plasma processing apparatus comprising a workpiece support and a RF supply for supplying a RF electrical signal with an associated RF power to the workpiece support; and
a module for removing the conductive layer from the plasma processed workpiece.

The plasma processing apparatus can be a plasma etch apparatus of any suitable type, such as an ICP (inductively coupled plasma) apparatus. The workpiece support can be any suitable type, such as an electrostatic chuck (ESC) or a platen.

The plasma processing apparatus can be a PECVD apparatus.

The module for removing the conductive layer from the plasma processed workpiece can comprise one or more of a tape peeling device, a wet etch apparatus or a grinding device.

According to a third aspect of the invention there is provided a workpiece processed by a method according to the first aspect of the invention and having an upper portion comprising at least one insulating layer and a lower surface opposite the upper portion.

The processed workpiece can be processed to produce a plurality of CMOS devices.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. Any features disclosed in relation to the first aspect of the invention may be combined with any features disclosed in relation to the second aspect of the invention and *vice versa* as appropriate.

### Description of the Drawings

Embodiments of the invention will now be described, by way of example only, with reference to the accompanying drawings, in which:
Figure 1 is a photograph of a wafer on a tape and frame carrier arrangement showing two regions of arcing;
Figure 2 shows a workpiece on a tape and frame arrangement of the invention;
Figure 3 shows a plasma dicing apparatus; and
Figure 4 is a cross sectional view of a workpiece of the invention.

### Detailed Description of the Disclosure

Without wishing to be bound by any particular theory or conjecture, plasma arcing is believed to be associated with either plasma instability or wafer structure. If the plasma is non-uniform over the wafer surface, a lateral potential drop with a voltage difference above the breakdown threshold will form a conductive current loop and cause the arcing. Alternatively, when high-order harmonics are present in the chamber, arcing will happen. **If** metal structures on the wafer surface become exposed, the plasma will locally respond to the impedance change via AC coupling and breakdown, potentially causing arcing. Alternatively, if the substrate support is electrically non-uniform, breakdown and arcing will occur when a large enough bias voltage is applied to the workpiece support. The present invention provides a removable, additional conductive layer on the backside of the workpiece. By attaching the removable, additional conductive layer in this way, it is possible to modify the backside of the workpiece to be conductive, forming an electrostatic surface. Again, without wishing to be bound by any particular theory or conjecture, it is believed that this surface electrostatically shields the workpiece support from at least the peaks of the non-uniformity. This electrostatic shielding improves plasma uniformity via AC coupling. The present invention can at least reduce the frequency of arcing in all of the scenarios mentioned above apart from the scenario where metal structures on the surface of the workpiece become exposed during etching.

The conductive layer can be provided as part of a tape and frame arrangement. An example is shown in Figure 2, which depicts a tape and frame arrangement 20 with a wafer workpiece 22 positioned thereon. The tape and frame arrangement 20 comprises a conductive tape 24 which is retained by a frame 26. The wafer workpiece 22 is positioned in contact with the conductive tape 24. Tape and frame carriers are commonly used to carry and support a workpiece which undergoes plasma dicing to singulate or nearly singulate the workpiece. It is advantageous that an entirely conventional tape and frame arrangement can be used, excepting the fact that the tape is a conductive tape. It is also highly advantageous that the conductive tape can be provided economically and easily, for example by using an anti-ESD tape. Tape of this type is readily available commercially. However, the invention is not limited to plasma dicing and instead can be used in conjunction with other plasma processing techniques such as other forms of plasma etching and PECVD.

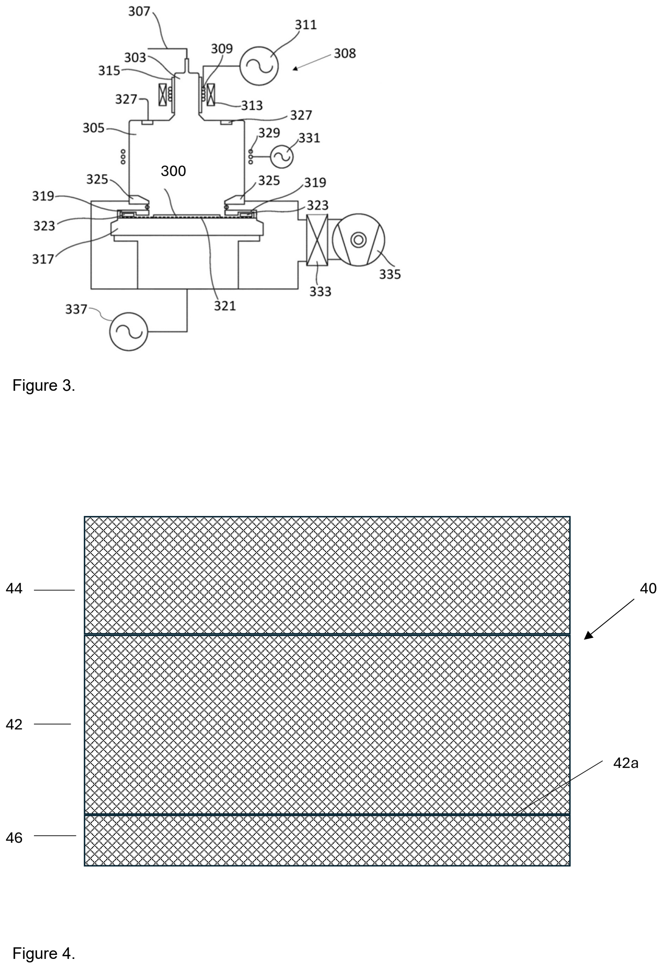

The conductive layer can be provided in other ways. For example, it is possible to coat a conductive layer on the back of the workpiece before plasma processing. Figure 4 shows a cross sectional view of a workpiece 40 of this type comprising a silicon substrate 42 having an upper portion 44 comprising an insulating layer, such as a silicon oxide layer. The silicon substrate 42 has a lower surface 42a which is coated with the conductive layer 46. Any suitable method, such as PVD, thermal sputtering or coating with conductive silver, carbon ink or soldering glue can be used to coat the workpiece. It is also possible to laminate the back of the workpiece with a conductive tape before plasma processing. All of these coating and lamination techniques can used in connection with plasma dicing or with other plasma processing techniques such as other forms of plasma etching and PECVD.

Experimental tests were carried out on an SPTS Mosaic^{™} plasma etch system (available commercially from SPTS Technologies Limited, Newport, UK). This is a DRIE system which uses an inductively coupled plasma (ICP) source. Figure 3 provides a schematic representation of the etch system shown generally at 308. The primary gas feed 307 enters the primary chamber 303 (a dielectric cylinder of 7-12cm diameter) which has an associated primary ionization source 311. An RF antenna 309 (nominally operating at 13.56 MHz) acts as the ICP source. This can be assisted by a DC coil 313 to modify the confinement of the plasma. A Faraday shield 315 can be provided between the DC coil 313 and the wall of the primary chamber 303 to reduce capacitive coupling. The plasma from the primary source enters the main chamber 305 where the wafer 300 is carried on a tape 321 and frame 323 carrier arrangement and placed on the wafer support 317, which may be an electrostatic chuck. The wafer size can be up to 300 mm in standard production applications, although processing of still larger wafers is within the scope of the invention. The frame 323 and tape 321 are protected by a wafer edge protection (WEP) device 319 to protect the frame and tape. The main (secondary) chamber 305 has a secondary ionization source 331 having a secondary RF coil 329 placed around the main chamber 305 to provide a secondary plasma close to the chamber wall. The RF coil 329 could also operate at 13.56 MHz or a lower frequency such as 1-2MHz. An annular gas distribution system 327 is incorporated into the main chamber 305 to provide an independent gas source for the secondary plasma. An RF power source 337 operating at 13.56 MHz provides an RF bias to the wafer support. A conductance limiting pathway is introduced at the wafer edge. Gas flows above the WEP 319 and below an annular baffle 325 in a radial fashion to a pump 335 through a gate valve 333. Regions of the chamber in the plane of the ICP coils are constructed from a dielectric material such as Al₂O₃ while the bulk of the chamber is constructed using aluminum or steel and is grounded.

Tests were performed using 300mm diameter silicon wafers with a 5-10 micron thick upper layer of silicon oxide. A 3-15 micron thick photoresist mask was deposited on to the upper layer to define openings for plasma dicing. Tests were performed using conventional insulating tape and anti-static conducting tape as the tape 321 of the tape and frame carrier arrangement. The plasma dicing was carried out using a high etch rate oxide etch process which provided an etch rate of around 0.9mm/min. Representative conditions are shown in Table 1 below. In Table 1, ICP 1 corresponds to the power supply 311 in the primary chamber while ICP 2 relates to power supply 311 in the main chamber.

**Table 1. Representative SiO₂ etch parameters for anti-arcing tests.**

| Parameter | Value |
|---|---|
| ICP 1 power (kW) | 2 |
| ICP 2 power (kW) | 2.45 |
| Bias power (kW) | 3 |
| Ar flow (sccm) | 162 |
| O₂ flow (sccm) | 2 |
| C₄F₈ flow (sccm) | 10 |
| SF₆ flow (sccm) | 48 |

Arcing was frequently observed while running with conventional insulating tape. However, arcing was not observed while using anti-static conducting carrier tape.

Following the plasma processing, the conductive layer is removed from the plasma processed workpiece. This can be performed in a number of ways depending on the nature of the conductive layer used. When plasma dicing CMOS wafers with thick dielectric layers above the scribe lines, vacuum deposited metal layers can be removed by a wet chemical etch, dependent on the metal, which selectively removes the backside metal while any frontside metal is protected. With a DBG process, vacuum deposited metal could be wet etched and/ or ground followed by wafer thinning. If conductive tape is used as the conductive layer, then the conductive tape can be peeled from the wafer or die removed from the tape. With a DAG process, a preferred approach is to use a conductive tape which is easily removed after singulation.

## Claims

1. A method of plasma processing a workpiece that is susceptible to arcing comprising the steps of:
providing a workpiece having an upper portion comprising at least one insulating layer and a lower surface opposite the upper portion;
applying a conductive layer to the lower surface;
positioning the workpiece on a workpiece support of a plasma processing apparatus with the lower surface of the workpiece closest to the workpiece support;
plasma processing the workpiece in the plasma processing apparatus, wherein the plasma processing comprises applying a RF electrical signal with an associated RF power to the workpiece support; and
removing the conductive layer from the plasma processed workpiece.

2. A method according to claim 1, in which the insulating layer is a SiO₂, SiN or SiCO layer or in which the insulating layer is a SiC or SiC:H layer.

3. A method according to any previous claim, in which the insulating layer is formed on a semiconductor substrate, optionally in which the semiconductor substrate is a silicon substrate.

4. A method according to any previous claim where the at least one insulating layer has a thickness of greater than 3 microns.

5. A method according to any previous claim, in which the plasma processing is plasma etching of the insulating layer, optionally in which the plasma etching is performed using at least one fluorocarbon and/or SF₆ as etch gases, optionally with at least one of oxygen, CO and an inert gas present.

6. A method according to claim 5, in which the workpiece is positioned on a tape and frame carrier arrangement, wherein: the plasma processing of the workpiece is a plasma dicing process; and the step of positioning the workpiece on the workpiece support is performed by positioning the tape and frame carrier arrangement carrying the workpiece on the workpiece support.

7. A method according to any one of claims 1 to 3, in which the plasma processing is plasma enhanced chemical vapour deposition (PECVD).

8. A method according to any previous claim, in which the step of applying a conductive layer to the lower surface comprises coating the lower surface with a conductive layer, optionally in which the conductive layer is a metal, further optionally, in which the lower surface is coated in a physical vapour deposition (PVD) or thermal sputtering process or is coated by applying a coating composition thereto.

9. A method according to any previous claim, in which the step of applying a conductive layer to the lower surface comprises laminating the lower surface with a conductive layer.

10. A method according to claim 9, in which the lower surface is laminated with a conductive tape.

11. A method according to claim 10 when dependent on claim 6, in which the conductive tape is the tape of the tape and frame carrier arrangement, and the lower surface is laminated by positioning the workpiece on the tape and frame carrier arrangement.

12. A method according to claim 10 when dependent on claim 6, in which the lower surface is laminated with the conductive tape and subsequently the workpiece is positioned on the tape and frame carrier arrangement.

13. A method according to any previous claim, in which a RF power of 1.5 kW or greater is supplied to the workpiece support.

14. A system for plasma processing a workpiece that is susceptible to arcing in a method according to claim 1, the system comprising:
a module for applying a conductive layer to the lower surface of the workpiece;
a plasma processing apparatus comprising a workpiece support and a RF supply for supplying a RF electrical signal with an associated RF power to the workpiece support; and
a module for removing the conductive layer from the plasma processed workpiece.

15. A workpiece processed by a method according to claim 1 and having an upper portion comprising at least one insulating layer and a lower surface opposite the upper portion.
